# EUROPEAN PATENT APPLICATION

(11) **EP 4 641 635 A1**
(43) Date of publication of application: **29.10.2025**
(21) Application number: 24204405.5
(22) Date of filing: 03.10.2024
(51) Int. Cl.: H01L 23/538, H01L 21/56, H01L 21/683, H01L 23/31, H01L 23/00

(54) **METHOD OF MANUFACTURING FAN-OUT PACKAGING DEVICE AND FAN-OUT PACKAGING DEVICE MANUFACTURED THEREBY**

(30) Priority: 26.04.2024 KR 20240056012
(71) Applicant: Silicon Box Pte. Ltd., Singapore 529580 (SG)
(72) Inventor: HAN, Byung Joon, 06067 SEOUL (KR); AHN, Byung Hoon, 16941 GYEONGGI-DO (KR)
(74) Representative: Cabinet Beaumont

(57) **Abstract**

Disclosed is a method of manufacturing a fan-out packaging device using wafer or panel level packaging including forming a temporary adhesive layer on a carrier substrate, attaching a die to the temporary adhesive layer, attaching a preformer, molding the die and the preformer on the temporary adhesive layer, separating the fan-out packaging substrate from the carrier substrate and the temporary adhesive layer, forming a temporary protective layer, forming a rear metal layer connected to the metal via, and removing the temporary protective layer and then forming a re-distribution line structure, and a bump structure connected to the re-distribution line structure.

## Description

### BACKGROUND OF THE INVENTION

### Field of the Invention

The present disclosure relates to a method of manufacturing a fan-out packaging device and a fan-out packaging device manufactured thereby and more specifically, to a fan-out packaging device that includes a preformer containing metal via and a rear metal layer on a fan-out packaging substrate to improve thermal, electrical and mechanical characteristics.

### Description of the Related Art

Eight major semiconductor processes include a wafer process, an oxidation process, a photo process, an etching process, a thin film process, a wiring process, a test process, and a packaging process.

The present invention relates to a packaging process among semiconductor processes. Generally, the semiconductor packaging process includes wafer cutting, die attach, die interconnection, molding, and packaging test.

A conventional semiconductor packaging process involves cutting the wafer and then the packaging process. On the other hand, recently, "wafer level packaging (WLP)" of maintaining the die in the wafer state has been performed. The WLP is performed by packaging a wafer and testing, and then cutting the die (chip) and has an advantage of reducing production cost compared to the conventional method.

In addition, research is actively underway on the panel level packaging (PLP), in addition to wafer level packaging. PLP has an advantage of further reducing production costs due to the greater number of dies that can be packaged compared to the WLP.

Meanwhile, in accordance with high-integration, high performance, and miniaturization of semiconductor devices, various packaging technologies are evolving based on the wafer-level or panel-level packaging, and active research is underway on fan-in (wafer or panel) level packaging, fan-out wafer or panel level packaging and the like.

In particular, fan-out wafer or panel level packaging (referred to hereinafter as "fan-out wafer level packaging" for convenience, and also called "Fan Out WLP" or "FO-WLP" if necessary) is performed in a fan-out manner to increase the number of I/O pins. This method can expand the scope of wiring formation beyond the die area using a RDL (re-distribution layer) process, thereby securing a larger wiring forming surface compared to the die size.

In this fan-out wafer level packaging, the RDL includes forming a dielectric layer on the die surface, forming a wiring layer using copper plating, and repeating this process as necessary to expand the range of wiring formation outside the die.

Here, in order to improve the yield and contact resistance of the wiring layer using the RDL process, it is very important to improve the quality of the plating layer during the copper plating process.

In the related art, attempts have been made to slow down the plating speed or improve the plating process conditions to improve the quality of the plating layer. However, these attempts slow down the process speed and do not ensure process reproducibility.

In addition, when the RDL wiring layer includes a plurality of layers, a dielectric layer is formed between the plating processes, which cause problems such as unevenness of the dielectric layer and deterioration of the surface topology due to the deterioration in quality of the plating layer and ultimately results in defects in the wiring layer due to the subsequent RDL process. This causes an increase in contact resistance or impedance, which has the disadvantage of a low operating frequency.

In addition, in the conventional fan-out packaging process, the packaging device may be influenced by the temperature for forming a redistribution layer (RDL) or the stress during the process, may be bent or twisted (the occurrence of wafer warpage) and thus be seriously defective. In addition, stress imbalance may occur overall in the fan-out packaging substrate due to the size of the die embedded on the fan-out packaging substrate, the number of dies, the arrangement of the die, the shape and type of the die and the like, depending on the type of the fan-out packaging device.

Meanwhile, the heat generated in the die is released through the active area of the die and the rear surface of the die. For this purpose, a heat spreader is attached to the rear surface of the die. This may cause drawbacks of complicated process and increased volume of the packaging device.

As such, there is still a lack of technology for improving the thermal, electrical and mechanical characteristics of the conventional fan-out packaging process and the fan-out packaging device manufactured thereby.

### SUMMARY OF THE INVENTION

Therefore, the present invention has been made in view of the above problems, and it is an object of the present invention to provide a fan-out packaging device that includes a preformer including a metal via and a rear metal layer on a fan-out packaging substrate to improve thermal, electrical and mechanical characteristics.

In accordance with one aspect of the present invention, the above and other objects can be accomplished by the provision of a method of manufacturing a fan-out packaging device using wafer or panel level packaging including forming a temporary adhesive layer on a carrier substrate, attaching a die to the temporary adhesive layer such that an active side of the die faces the temporary adhesive layer, attaching a preformer including a metal via in an area of the temporary adhesive layer where the die is not present, molding the die and the preformer on the temporary adhesive layer to form a fan-out packaging substrate, separating the fan-out packaging substrate from the carrier substrate and the temporary adhesive layer, forming a temporary protective layer on the active side of the separated fan-out packaging substrate, forming a rear metal layer connected to the metal via on the rear surface of the fan-out packaging substrate, and removing the temporary protective layer and then forming a re-distribution line structure connected to the metal via at the active side of the fan-out packaging substrate and ground-connected to the rear metal layer, and a bump structure connected to the re-distribution line structure.

In accordance with another aspect of the present disclosure, provided is a fan-out packaging device using wafer or panel level packaging including a fan-out packaging substrate embedded with a die and a preformer including a metal via, a rear metal layer formed on a rear surface of the fan-out packaging substrate and connected to the metal via, and a re-distribution line structure connected to the metal via at the active side of the fan-out packaging substrate and ground-connected to the rear metal layer, and a bump structure connected to the re-distribution line structure.

In addition, the preformer may be formed by forming a metallization pattern on a support substrate or may be formed by forming the metallization pattern on the support substrate and then dicing the metallization pattern into one or more fragments with a predetermined size.

In addition, the preformer may include a support, one or more through holes penetrating the support in a vertical direction, and a metal via configured to provide electrical connection in a vertical direction in the through holes.

In addition, the metal via may be formed on the inner wall of the through hole by a plating process such that the metal via includes the through hole or fills the through hole.

In addition, the preformer may include a contact pad connected to the metal via and formed along a circumference of the through hole. One or more preformers including the preformer may be symmetrical based on the die.

In addition, the rear metal layer may contain a copper (Cu) material. The rear metal layer may be formed as a copper layer on a titanium (Ti) or titanium tungsten (TiW) layer. The rear metal layer may have a thickness of 1 to 2.2 µm.

### BRIEF DESCRIPTION OF THE DRAWINGS

The above and other objects, features, and other advantages of the present disclosure will be more clearly understood from the following detailed description taken in conjunction with the accompanying drawings, in which:
FIG. 1 is a side schematic diagram illustrating a method of manufacturing a fan-out packaging device according to an embodiment of the present invention;
FIGS. 2A, 2B, 3A and 3B are side schematic diagrams illustrating main components of a fan-out packaging device according to various embodiments of the present invention; and
FIGS. 4 to 5 are plan side schematic diagrams illustrating main components of a fan-out packaging device according to various embodiments of the present invention.

### DETAILED DESCRIPTION OF THE INVENTION

The present invention is directed to a fan-out packaging device using wafer or panel level packaging that includes a preformer including a metal via and a rear metal layer on a fan-out packaging substrate to improve thermal, electrical and mechanical characteristics.

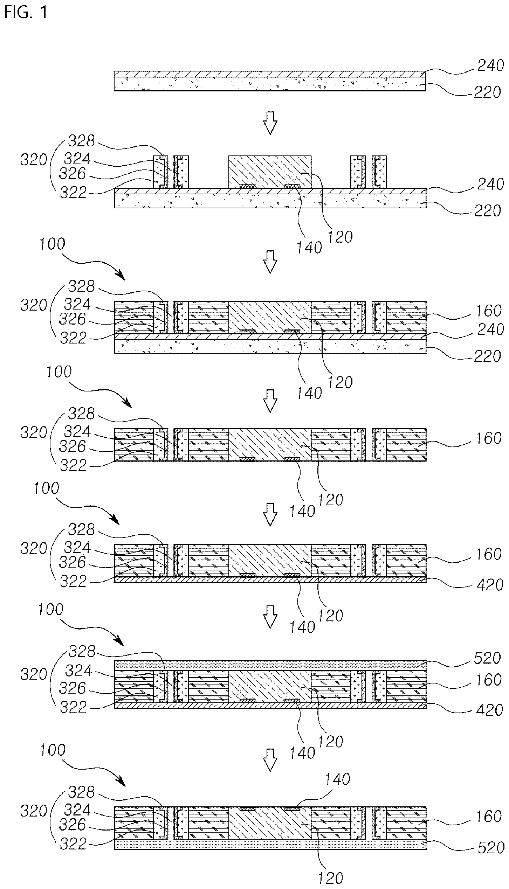

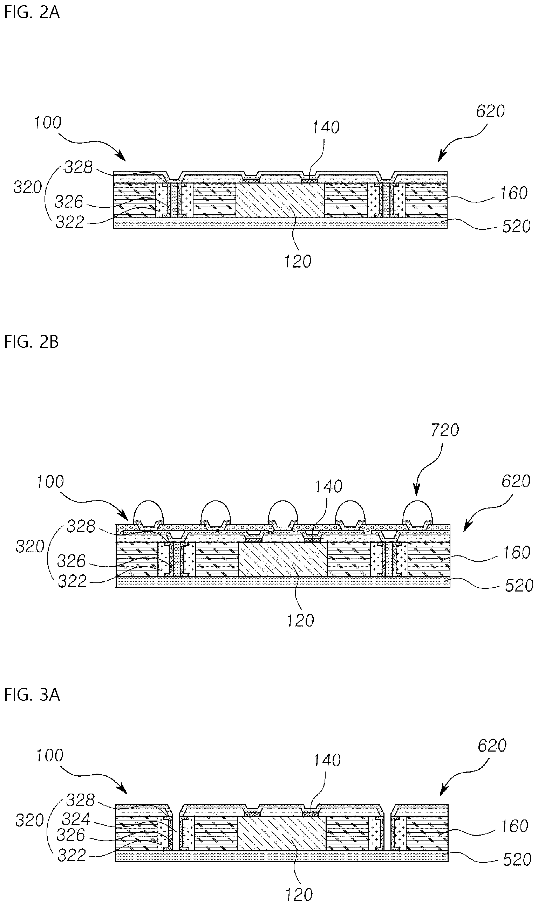

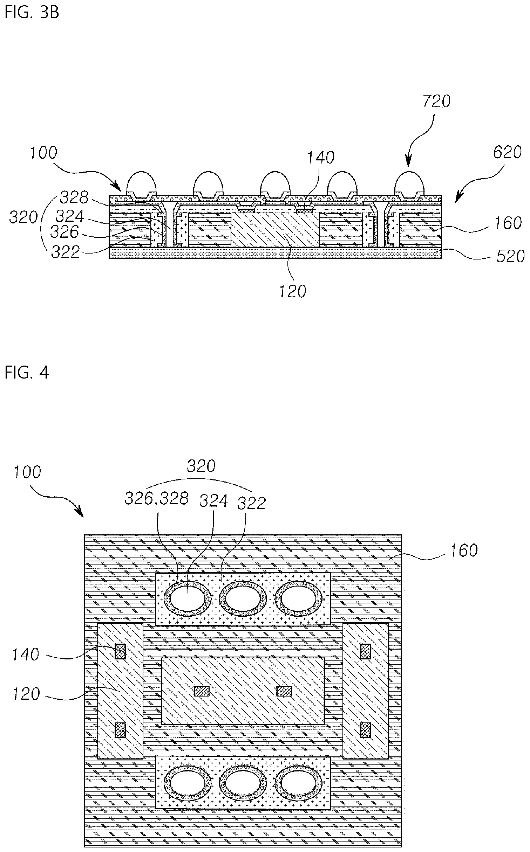

Hereinafter, embodiments of the present invention will be described in detail with reference to the annexed drawings. FIG. 1 is a side schematic diagram illustrating a method of manufacturing a fan-out packaging device according to an embodiment of the present invention, FIGS. 2 and 3 are side schematic diagrams illustrating main components of a fan-out packaging device according to various embodiments of the present invention, and

FIGS. 4 to 5 are plan side schematic diagrams illustrating main components of a fan-out packaging device according to various embodiments of the present invention.

As shown in FIG. 1, a method of manufacturing a packaging device using a wafer or panel level packaging process includes forming a temporary adhesive layer 240 on a carrier substrate 220, attaching a die 120 to the temporary adhesive layer 240 such that an active side of the die 120 faces the temporary adhesive layer 240, attaching a preformer 320 including a metal via 326 in an area of the temporary adhesive layer 240 where the die 120 is not present, forming a molding 160 of the die 120 and the preformer 320 on the temporary adhesive layer 240 to form a fan-out packaging substrate 100, separating the fan-out packaging substrate 100 from the carrier substrate 220 and the temporary adhesive layer 240, forming a temporary protective layer 420 on the active side of the separated fan-out packaging substrate 100, forming a rear metal layer 520 connected to the metal via 326 on the rear surface of the fan-out packaging substrate 100, and removing the temporary protective layer 420 and then forming a re-distribution line structure 620 connected to the metal via 326 at the active side of the fan-out packaging substrate 100, and ground-connected to the rear metal layer 520, and a bump structure 720 connected to the re-distribution line structure 620.

The fan-out packaging device according to an embodiment of the present invention manufactured by the method is a packaging device using a wafer or panel level packaging process, and includes a fan-out packaging substrate embedded with a die 120 and a preformer 320 including a metal via 326, a rear metal layer 520 formed on the rear surface of the fan-out packaging substrate 100 and connected to the metal via 326, a re-distribution line structure 620 connected to the metal via 326 at the active side of the fan-out packaging substrate 100 and ground-connected to the rear metal layer 520, and a bump structure 720 connected to the re-distribution line structure 620.

The present invention is directed to a method of manufacturing a packaging device using a wafer or panel level packaging process. First, a temporary adhesive layer 240 is formed on the carrier substrate 220.

The carrier substrate 220 is a temporary substrate to reconstruct the die 120 and the preformer 320, which will be described later and may be formed of a hard material such as metal, glass, oxide or PCB to support the die 120 and the preformer 320.

The temporary adhesive layer 240 (release tape, die-attach film) is formed on the carrier substrate 220. The temporary adhesive layer 240 functions to separate the carrier substrate 220 from the structures formed on the carrier substrate 220. The temporary adhesive layer 240 according to an embodiment of the present invention may be formed of an epoxy adhesive substance or a photosensitive material that is degraded by heat or light. The temporary adhesive layer 240 may be formed by stacking or coating a material on the carrier substrate 220 and may be cured by heat or light after the die 120 is attached thereto, as necessary.

Then, the die 120 is attached to the temporary adhesive layer 240 so that the active side of the die 120 faces the temporary adhesive layer 240. The active side of the die 120 refers to the surface of the die 120 where a signal pad 140 is exposed, and the active side of the die 120 is brought into contact with the temporary adhesive layer 240 (die face down process). As a result, the die 120 is reconstructed on the temporary adhesive layer 240 and this is carried out using a pick-and-place process, or the like.

Then, a preformer 320 including a metal via 326 is attached to the area of the temporary adhesive layer 240 where the die is not present. The die 120 is attached to the temporary adhesive layer 240 and the preformer 320 is spaced from the die 120 by an appropriate distance. One or more preformers 320 including the preformer 320 may be attached depending on the size of the fan-out packaging substrate 100, the size of the die 120, the number of dies 120, the arrangement state of the die 120, the shape and type of the die 120 and the like.

In the conventional fan-out packaging process, stress is generated due to the process temperature during formation of the redistribution layer (RDL) or the difference in CTE (coefficient of thermal expansion) during the process, thus causing the packaging device to be bent or twisted (the occurrence of wafer warpage) and thus be seriously defective. In addition, stress imbalance may occur overall in the fan-out packaging substrate due to the size of the die embedded on the fan-out packaging substrate, the number of dies, the arrangement of the die, the shape and type of the die and the like, depending on the type of the fan-out packaging device. That is, the thermal and mechanical stress generated in the fan-out packaging process leads to the distortion of the packaging element.

In the present invention, a predetermined number of the preformer 320 having a predetermined size and shape may be disposed at a specific location on the temporary adhesive layer 240 in order to solve the problem of stress imbalance.

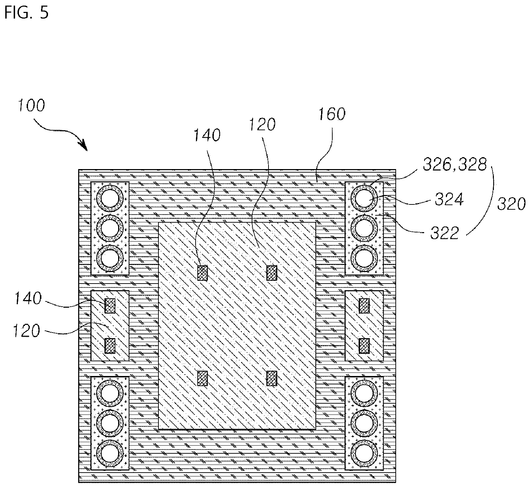

In one embodiment of the present invention, one or more of the preformer 320 may be symmetrical based on the die 120 (see FIGS. 4 and 5). That is, the preformers 320 are disposed on one side of the die 120, at the center of the disposed die 120, on both sides of the die 120, or along the circumference of the die 120. When two or more dies 120 with different sizes are disposed, the preformers 320 are disposed so as to reduce stress imbalance in consideration of the different sizes and functions to distribute the stress generated in the packaging device.

The preformer 320 according to an embodiment of the present invention includes a metal via 326. That is, the preformer 320 is spaced apart from the die 120 and the metal via 326 is formed in a vertical direction in the preformer 320 to electrically connect the upper and lower structures.

The preformer 320 is formed by forming a metallization pattern on a support substrate (not shown) or is formed by forming a metallization pattern on the support substrate and dicing the metallization pattern into one or more fragments with a predetermined size.

In the preformer 320 according to an embodiment of the present invention, metal layers are stacked on the upper and lower sides of the support substrate, through holes 324 are formed in a predetermined pattern, and a metal plating layer is formed in the through hole 324 to form a metal via 326. In this case, a contact pad 328 is formed on the upper and lower surfaces of the support substrate around the through hole 324 due to the stacked metal layers.

In addition, in the preformer 320 according to an embodiment of the present invention, the through hole 324 is formed in a support substrate, a metal via 326 is formed inside the through hole 324 through a patterning process and a contact pad 328 connected to the metal via 326 may be formed along the upper and lower circumferences of the hole 324. The contact pad 328 is preferably formed in a circular shape in accordance with the shape of the through hole 324.

The preformer 320 may be provided by forming a plurality of through holes 324 and the via metal on the support substrate (not shown) and then dicing the resulting structure to an appropriate size. That is, a plurality of preformers 320 with various sizes are provided so as to select one with an appropriate size from the preformers 320 to balance the stress of the above-described packaging device. The through hole 324 is formed by etching using a laser or a patterning process and the metal via 326 is formed in the through hole 324. This is called a "metallization pattern process" in the present invention.

The preformer 320 including the metal via 326 or the preformer 320 including a plurality of metal vias 326 diced to an appropriate size includes a support 322, one or more through holes 324 penetrating the support 322 in a vertical direction, and metal vias 326 configured to provide electrical connection in a vertical direction in the through holes 324.

A material for the support substrate, that is, the support 322 according to an embodiment of the present invention may be a PCB, silicon, ceramic, another organic material or the like. That is, any material may be used for the support substrate as long as it is easy to manufacture the metal via 326 and the through hole 324, can reduce stress imbalance in the packaging device, and is easily attached to the temporary adhesive layer 240.

The metal via 326 according to an embodiment of the present invention is formed on the inner wall of the through hole 324 by a plating process such that it includes or fills the through hole 324.

The metal via 326 may be plated and filled with various metal materials such as aluminum (Al), tungsten (W), titanium (Ti), and copper (Cu), the plating may be carried out by electroplating, and the filling may be carried out by processes such as sputtering, atomic layer deposition (ALD), and CVD, as needed. In an embodiment of the present invention, electroplating with excellent step coverage and excellent cost and productivity is used and copper is used as the metal material.

Then, a molding 160 of the die 120 and the preformer 320 is formed on the temporary adhesive layer 240 to form the fan-out packaging substrate 100. That is, the fan-out packaging substrate 100, in which the die 120 and the preformer 320 are embedded, is provided using an EMC (epoxy molding compound). In this way, the embedded die 120 is formed on a wafer or panel and the area outside the die 120 is provided as a fan-out area.

Then, the fan-out packaging substrate 100 is separated from the carrier substrate 220 and the temporary adhesive layer 240. As described above, the fan-out packaging substrate 100 is separated by the temporary adhesive layer 240 containing an epoxy-based adhesive material or a photosensitive material that is degraded by heat or light.

Then, a temporary protective layer 420 is formed on the active side of the separated fan-out packaging substrate 100. The temporary protective layer 420 aims at temporarily protecting the active side of the fan-out packaging substrate 100 during subsequent processes and may be an adhesive protective film or the like.

Then, a rear metal layer 520 connected to the metal via 326 is formed on the rear surface of the fan-out packaging substrate 100. The rear metal layer 520 is formed over the entire region of the rear surface of the fan-out packaging substrate 100 and is electrically connected to the metal via 326. The rear metal layer 520 is formed by known physical or chemical thin film deposition. In one embodiment of the present invention, the rear metal layer 520 is formed by a sputtering process.

In addition, a hole or roughness pattern may be formed in a part or entirety of the rear metal layer 520. The hole functions to distribute mechanical or thermal stress throughout the rear metal layer 520 (prevent warping of the wafer or panel).

In addition, in an embodiment of the present invention, the diameter of the hole and the roughness pattern is preferably less than twice the thickness of the rear metal layer 520 and this aims at distributing the mechanical or thermal stress.

In addition, the rear metal layer 520 is formed of a metal with excellent electrical and thermal conductivity and copper is used in the embodiment of the present invention. In addition, in order to improve the coatability and adhesivity with the surface of the fan-out packaging substrate 100, the rear metal layer 520 may be formed as a composite metal layer obtained by first forming a titanium (Ti) or titanium tungsten (TiW) layer, and then forming a copper layer on the titanium (Ti) or titanium tungsten (TiW) layer.

Overall, the thickness of the rear metal layer 520 may be 2.2 µm or less, preferably 1 to 2 µm, in consideration of the thickness and function of the device. The thickness of the titanium (Ti) or titanium tungsten (TiW) layer in the composite metal layer may be 0.05 to 0.1 µm.

The rear metal layer 520 serves as a seed layer during electroplating to form the re-distribution line structure 620 and the bump structure 720 in the subsequent process. This provides a very low impedance connection during the plating process, providing uniformity of the plating thickness in the re-distribution line structure 620 and the bump structure 720 without greatly reducing the plating speed, providing the seed layer with a large area and thus a maximized conductive layer, and improving the quality of the re-distribution line structure 620 and the bump structure 720. This may be more useful for formation of a plurality of redistribution layers 300.

In addition, when the subsequent metal layer according to the present invention is used as a ground plate, very high frequency operation is possible by providing a low impedance signal return path to the redistribution layer.

In addition, the rear metal layer 520 according to the present invention covers the die 120 by connection and ground-connection to the metal via 326 of the preformer 320, thereby providing an electromagnetic interference (EMI) shielding function and stable electrical operation.

Meanwhile, the heat generated in the die 120 is emitted through the active side of the die 120 and the rear surface of the die 120. For this purpose, a heat spreader is attached to the rear surface of the die 120. The rear metal layer 520 according to the present invention acts as a heat spreader to improve the thermal characteristics of the packaging device.

Then, after removing the temporary protective layer 420, a re-distribution line structure 620 connected to the metal via 326 on the active side of the fan-out packaging substrate 100 and ground-connected to the rear metal layer 520 and a bump structure 720 connected to the re-distribution line structure 620 are formed.

First, the re-distribution line structure 620 is formed as follows. A first dielectric layer is formed on the active side of the fan-out packaging substrate 100, the first dielectric layer is patterned to form a via hole, and a redistribution layer is formed on the first dielectric layer and the via hole.

The first dielectric layer is formed of an organic or inorganic dielectric material and may be formed of a polymer material such as polyimide, polybenzoxazole (PBO), or benzocyclobutene (BCB), or an inorganic material such as an oxide or nitride, preferably, silicon nitride or silicon oxide. In addition, in various embodiments, the first dielectric layer may be formed of an oxide such as SiO₂, SiOₓ, Al₂O₃, ZrOz, or TazOs, a nitride such as SiNx, Si₃N₄, ZrN, AlN, BN, TaN, or TaN, or a combination of two or more materials as needed. In addition, the material for the first dielectric layer may be the same as or different from the material for the second dielectric layer, which will be described later.

This dielectric layer may be formed by a process such as spin coating, chemical vapor deposition (CVD), sputtering, or laminating, or a combination thereof, and may be formed by appropriate physical and chemical vapor deposition processes.

Then, the first dielectric layer is patterned to form a via hole. The via hole is formed through etching using a patterning process and the via hole is filled with a metal and thus serves as an electrical connection path between the upper and lower components.

A plurality of via holes are formed in the first dielectric layer to expose the metal via 326 and the signal pad 140 of the preformer 320. In addition, the via hole is formed in the signal pad 140 of the die 120 as well. That is, a plurality of via holes are formed at appropriate positions on the first dielectric layer, to expose the metal via 326 of the preformer 320 and the signal pad 140. A plurality of via holes may be formed in other areas where needed.

The via hole may be filled with various metal materials such as aluminum (Al), tungsten (W), titanium (Ti), and copper (Cu) by sputtering, ALD (atomic layer deposition), CVD, and electroplating.

In an embodiment of the present invention, electroplating with excellent step coverage and excellent cost and productivity is used and copper is used as the metal material.

In addition, by forming the redistribution layer on the first dielectric layer and the via hole, the redistribution layer is electrically connected to the metal via 326 or the signal pad 140 of the die 120. The redistribution layer is obtained during the via hole formation process, or by forming the via hole, forming a metal layer on the first dielectric layer and forming a metallization pattern thereon.

That is, the redistribution layer according to an embodiment of the present invention is obtained by forming a copper layer by electroplating and then forming a signal line for rearrangement of the electrical connection lines of the signal pad 140 exposed from the die 120 through patterning and etching processes.

This redistribution layer may be implemented as a single, multi-, or double-sided redistribution layer. That is, a redistribution signal line is formed in the fan-out area by repeatedly forming the dielectric layer and the metal layer (repeatedly performing the first dielectric forming process and the redistribution layer forming process) to form a plurality of redistribution layers/dielectric layers.

As described above, the rear metal layer 520 is formed on the rear surface of the fan-out packaging substrate 100 according to an embodiment of the present invention, and the rear metal layer 520 serves as a seed layer during electroplating to form the redistribution layer and the bump structure 720 in the subsequent process to provide an additional path through which current flows, thereby improving the plating speed due to low impedance in the re-distribution line structure 620 and the bump structure 720, providing a seed layer with a large area and thus uniformity of the plating layer, and improving the quality of the re-distribution line structure 620 and the bump structure 720.

Then, a second dielectric layer is formed on the redistribution layer, and the second dielectric layer is patterned to form a bump structure 720 connected to the redistribution layer. The second dielectric layer is formed using the same or similar materials and processes as the first dielectric layer above and is then patterned to form a bump structure 720 connected to the redistribution layer.

Here, when a plurality of redistribution layers are formed, via holes are formed in the same manner as the first dielectric layer by patterning the second dielectric layer, redistribution layers are formed through a plating process, and then the redistribution layers are connected to each other. Here, the redistribution layer is ground-connected to the rear metal layer 520.

As shown in FIGS. 2A, 2B, 3A, and 3B, a first dielectric layer is formed on the active side of the fan-out packaging substrate 100, a redistribution layer is formed in the via hole and on the first dielectric layer, a second dielectric layer is formed thereon, and a bump structure is formed at a predetermined location through a patterning process.

FIG. 2A shows a configuration in which a first dielectric layer is formed on a fan-out packaging substrate 100 in which a preformer 320 having a metal via 326 completely filling the through hole is embedded, and a metal layer for forming a redistribution layer is formed on the first dielectric layer. FIG. 2B shows a configuration in which a re-distribution line structure 620 is formed by a patterning process for forming a redistribution layer and a bump structure 720 is formed on the re-distribution line structure 620.

FIG. 3A shows a configuration in which a re-distribution line structure 620 on a fan-out packaging substrate 100 in which a metal via 326 is formed on the inner wall of the through hole 324, and a preformer 320 having a metal via 326 including a hole is embedded. FIG. 3B shows a configuration in which a bump structure 720 is formed on the re-distribution line structure 620.

The bump structure 720 according to an embodiment of the present invention is formed by forming UBM (under bump metallization) on the pattern (or via hole) of the second dielectric layer (Ti/Cu layer deposition and patterning) and forming a solder bump by solder plating, removal of the photoresist, removal of unnecessary metal layers, and reflowing, and the solder bump and the UBM are referred to as "bump structure" for convenience in the present invention.

As such, the solder bump may be formed at the wafer or panel level, additional or general packaging processes may be performed, and then separation into unit fan-out packaging devices may be possible through a dicing process.

The present invention provides a fan-out packaging device that is imparted with improved thermal, electrical and mechanical characteristics by introducing a preformer including a metal via into the fan-out packaging substrate and forming a rear metal layer thereon.

In addition, the preformer according to the present invention is disposed at a specific location on the temporary adhesive layer in order to solve the problem of stress imbalance that occurs depending on the process or the size and arrangement of the die, to provide stress balance and distribute the stress occurring in the packaging device.

In addition, the rear metal layer according to the present invention serves as a seed layer during electroplating to form the redistribution layer and the bump structure in the subsequent process, thereby providing very low impedance connection in the plating process, providing uniformity of plating thickness in the redistribution layer and the bump structure without the necessity to significantly lower the plating speed, providing a maximized conductive layer through the seed layer with a large area, and improving the quality of the redistribution layer and the bump structure. The rear metal layer may be more useful for formation of a plurality of redistribution layers.

In addition, when the rear metal layer according to the present invention is used as a ground plate, it provides a low impedance signal return path to the redistribution layer 300, thus enabling very high frequency operation.

In addition, the rear metal layer according to the present invention covers the die by connection and ground-connection to the metal via of the preformer, thereby providing an electromagnetic interference (EMI) shielding function and stable electrical operation.

Meanwhile, the heat generated in the die is emitted through the active side of the die and the rear surface of the die. For this purpose, a heat spreader is attached to the rear surface of the die. The rear metal layer according to the present invention acts as a heat spreader to improve the thermal characteristics of the packaging device.

As apparent from the foregoing, in according to the present invention, the fan-out packaging device that is imparted with improved thermal, electrical and mechanical characteristics by introducing a preformer including a metal via into the fan-out packaging substrate and forming a rear metal layer thereon.

In addition, the preformer according to the present invention is disposed at a specific location on the temporary adhesive layer in order to solve the problem of stress imbalance that occurs depending on the process or the size and arrangement of the die, to provide stress balance and distribute the stress occurring in the packaging device.

In addition, the rear metal layer according to the present invention serves as a seed layer during electroplating to form the redistribution layer and the bump structure in the subsequent process, thereby providing very low impedance connection in the plating process, providing uniformity of plating thickness in the redistribution layer and the bump structure without the necessity to significantly lower the plating speed, providing a maximized conductive layer through the seed layer with a large area, and improving the quality of the redistribution layer and the bump structure. The rear metal layer may be more useful for formation of a plurality of redistribution layers.

In addition, when the rear metal layer according to the present invention is used as a ground plate, it provides a low impedance signal return path to the redistribution layer 300, thus enabling very high frequency operation.

In addition, the rear metal layer according to the present invention covers the die by connection and ground-connection to the metal via of the preformer, thereby providing an electromagnetic interference shielding (EMI) function and stable electrical operation.

Meanwhile, the heat generated in the die is emitted through the active side of the die and the rear surface of the die. For this purpose, a heat spreader is attached to the rear surface of the die. The rear metal layer according to the present invention acts as a heat spreader to improve the thermal characteristics of the packaging device.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A method of manufacturing a fan-out packaging device using wafer or panel level packaging comprising:
forming a temporary adhesive layer on a carrier substrate;
attaching a die to the temporary adhesive layer such that an active side of the die faces the temporary adhesive layer;
attaching a preformer including a metal via in an area of the temporary adhesive layer where the die is not present;
molding the die and the preformer on the temporary adhesive layer to form a fan-out packaging substrate;
separating the fan-out packaging substrate from the carrier substrate and the temporary adhesive layer;
forming a temporary protective layer on the active side of the separated fan-out packaging substrate;
forming a rear metal layer connected to the metal via on a rear surface of the fan-out packaging substrate; and
removing the temporary protective layer and then forming a re-distribution line structure connected to the metal via at the active side of the fan-out packaging substrate and ground-connected to the rear metal layer, and a bump structure connected to the re-distribution line structure.

2. The method according to claim 1, wherein the preformer is formed by forming a metallization pattern on a support substrate or is formed by forming the metallization pattern on the support substrate and then dicing the metallization pattern into one or more fragments with a predetermined size.

3. The method according to claim 1, wherein preformer comprises:
a support;
one or more through holes penetrating the support in a vertical direction; and
a metal via configured to provide electrical connection in a vertical direction in the through holes.

4. The method according to claim 3, wherein the metal via is formed on an inner wall of the through hole by a plating process such that the metal via includes a hole or fills the through hole.

5. The method according to claim 4, wherein the preformer comprises a contact pad connected to the metal via and formed along a circumference of the through hole.

6. The method according to claim 1, wherein one or more preformers including the preformer are symmetrical based on the die.

7. The method according to claim 1, wherein the rear metal layer comprises a copper (Cu) material.

8. The method according to claim 7, wherein the rear metal layer is formed as a copper layer on a titanium (Ti) or titanium tungsten (TiW) layer.

9. The method according to claim 1, wherein the rear metal layer has a thickness of 1 to 2.2 µm.

10. A fan-out packaging device using wafer or panel level packaging comprising:
a fan-out packaging substrate embedded with a die and a preformer including a metal via;
a rear metal layer formed on a rear surface of the fan-out packaging substrate and connected to the metal via; and
a re-distribution line structure connected to the metal via at an active side of the fan-out packaging substrate and ground-connected to the rear metal layer, and a bump structure connected to the re-distribution line structure.

11. The fan-out packaging device according to claim 10, wherein the preformer is formed by forming a metallization pattern on a support substrate or is formed by forming the metallization pattern on the support substrate and then dicing the metallization pattern into one or more fragments with a predetermined size.

12. The fan-out packaging device according to claim 11, wherein the preformer comprises:
a support;
one or more through holes penetrating the support in a vertical direction; and
a metal via configured to provide electrical connection in a vertical direction in the through holes.

13. The fan-out packaging device according to claim 12, wherein the metal via is formed on an inner wall of the through hole by a plating process such that the metal via includes the through hole or fills the through hole.

14. The fan-out packaging device according to claim 13, wherein the preformer comprises a contact pad connected to the metal via and formed along a circumference of the through hole.

15. The fan-out packaging device according to claim 10, wherein one or more preformers including the preformer are symmetrical based on the die.
